(19) Europäisches Patentamt
European Patent Office
Office européen des brevets

(11) **EP 1 758 249 A1**

(12) **DEMANDE DE BREVET EUROPEEN**

(43) Date de publication:
**28.02.2007 Bulletin 2007/09**

(51) Int Cl.:
**H03K 3/3565** (2006.01)

(21) Numéro de dépôt: **06119192.0**

(22) Date de dépôt: **18.08.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **22.08.2005 FR 0508667**

(71) Demandeur: **ATMEL NANTES SA**
**44306 Nantes Cédex 3 (FR)**

(72) Inventeur: **Chatal, Joël**
**44470 Carquefou (FR)**

(74) Mandataire: **Bioret, Ludovic**
**Cabinet Vidon**
**16 B, rue de Jouanet - B.P. 90333**
**35703 Rennes Cedex 07 (FR)**

(54) **Comparateur à hystérésis de tensions d'entrée et circuit électronique correspondant**

(57)     L'invention concerne un comparateur d'une première tension d'entrée (Vinn) et d'une seconde tension d'entrée (Vinp) à hystérésis, comprenant un premier étage différentiel dont des première et seconde entrées sont alimentées respectivement par lesdites première et seconde tensions d'entrée.

Selon l'invention, un tel comparateur comprend au moins un second étage différentiel symétrique dudit premier étage différentiel, deux entrées dudit second étage différentiel étant alimentées respectivement par une première (VREF1) et une seconde tensions de référence (VREF1+VTH),

Il comprend également des moyens de comparaison d'au moins un premier courant (I2), dépendant de la différence entre les première (Vinn) et seconde (Vinp) tensions d'entrée, à au moins un second courant (Irefn, Irefp) dépendant de la différence (VTH) entre les seconde et première tensions de référence.

Fig. 3

**Description**

### 1. Domaine de l'invention

Le domaine de l'invention est celui des dispositifs électroniques permettant la comparaison de tensions.

Plus précisément, l'invention concerne les comparateurs de tensions dont le principe de fonctionnement repose sur la comparaison de courants dépendant de ces tensions.

### 2. Solutions de l'art antérieur

En sortie de la plupart des comparateurs de tensions basés sur une comparaison de courants, on peut observer un phénomène d'hystérésis dont l'amplitude dépend du ou des procédé(s) mis en oeuvre pour réaliser ces comparateurs (encore appelés process de fabrication), de la température et de la tension d'alimentation des comparateurs.

On rappelle que si l'on considère une grandeur cause notée C produisant une grandeur effet notée E. On dira qu'il y a hystérésis sur une courbe $E = f(C)$ lorsque cette courbe obtenue à la croissance de C ne se superpose pas avec cette même courbe obtenue à la décroissance de C. Généralement, la raison en est que les variations de E se font avec un certain décalage par rapport à celles de C, ce décalage produisant des discontinuités lors de l'inversion du sens de la variation de C.

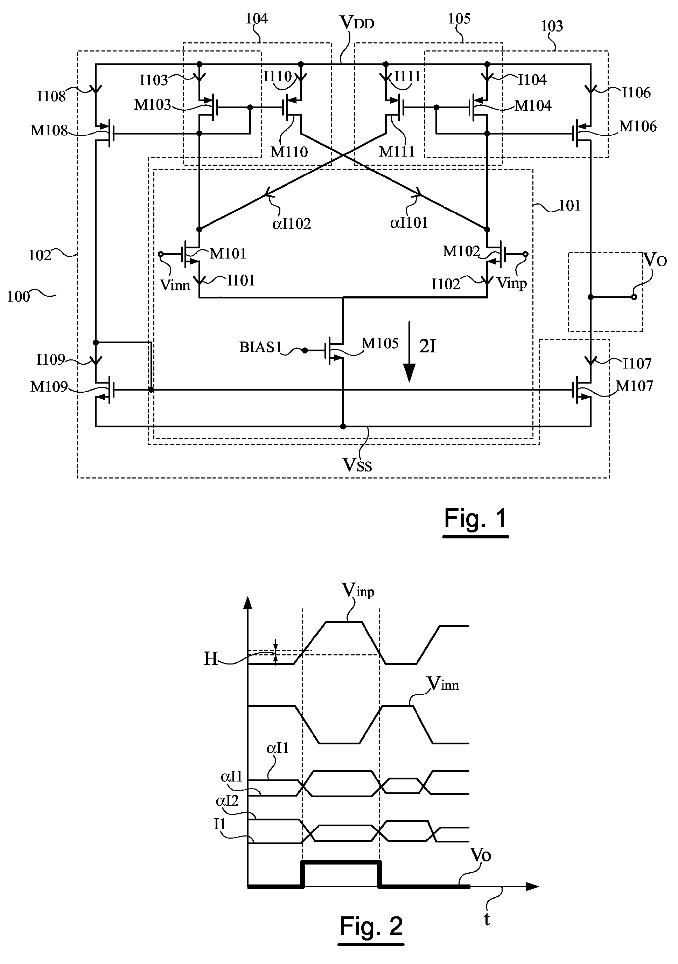

On décrit, en relation avec la *figure 1,* le fonctionnement d'un comparateur 100 couplé croisé bistable qui est un comparateur classique à hystérésis.

Le comparateur 100 comprend :

- un étage différentiel 101 comprenant une paire de transistors MOS M101, M102 et un transistor MOS M105 réalisant la fonction de convertisseur tension/courant, la grille du transistor M105 étant reliée à un potentiel BIAS1 qui est par exemple égal à 1V ;
- un premier miroir de courant 102 comprenant quatre transistors MOS M103, M107, M108, M109 ;
- un second miroir de courant 103 comprenant deux transistors MOS M104 et M106 ;
- un troisième miroir de courant 104 comprenant deux transistors MOS M103 et M110 ;
- un quatrième miroir de courant 105 comprenant deux transistors MOS M104 et M111.

Le comparateur 100 est référencé par un potentiel VSS qui est, par exemple la masse.

Les transistors M108, M109, M110, M111, M104 et M106 sont des transistors MOS de type P, les autres transistors précités sont des MOS de type N.

Le transistor M1i, pour i compris entre 01 et 11, possède un canal de largeur W1i et de longueur L1i.

On se place dans le cas où les relations suivantes sont vérifiées :

- W102 = W101 ;
- L102 = L101 ;
- W103 = W107 = W108 = W109;
- L103 = L107 = L108 = L109;
- W104 = W106;
- L104 = L106;
- W103 = $\alpha$.W110 ;
- L103 = L110 ;
- W104 = $\alpha$.W111 et
- L104 = L111

où $\alpha$ est un facteur compris entre 0 et 1.
Si Vinn << Vinp:

- I101 = I103 = I110 = 0;
- I102 = I104 = I106 = 2I et
- V0 = VDD.

où I101, I102, $\alpha$I101 et $\alpha$I102 sont respectivement les courants circulant dans les transistors M101, M102, M110 et M111.

Si Vinn-Vinp augmente, la transition de la tension de sortie V0 du comparateur 100 de sa valeur haute VDD à sa valeur basse de 0V intervient lorsque :

$$I101 = I111 = \alpha.I104 = \alpha.I102$$

Si Vinp << Vinn :

- I101 = I103 = I110 = 2I;
- I102 = I104 = I106 =0 et
- V0 = 0.

Si Vinp-Vinn augmente, la transition de la tension de sortie V0 du comparateur 100 de sa valeur basse de 0V à sa valeur haute VDD intervient lorsque :

$$I102 = I110 = \alpha.I103 = \alpha.I101$$

La transition de la tension de sortie V0 de sa valeur haute à sa valeur basse intervient lorsque :

$$I101 = \alpha.I102$$

avec :

- $I101 = \upsilon\, C0.W101/L101.(Vgs101-VT)^2$;
- $I102 = \upsilon\, C0.W102/L102.(Vgs102-VT)^2$ et
- I101 + I102 = 2I

Ainsi, la transition de la tension de sortie V0 de sa valeur haute à sa valeur basse intervient lorsque :

$$Vinn\text{-}Vinp = Vgs101\text{-}Vgs102 = K[(2I/(1+\alpha))^{1/2}-(2\alpha I/(1+\alpha))^{1/2}]$$

avec :

- $K = (L.q/W.kT.\upsilon.C0)^{1/2}$ ;
- k est la constante de Boltzmann ;
- $q = 1,6.10^{-19}$ ;
- T est la température :
- $\upsilon$ et C0 sont des paramètres physiques dépendant de la technologie mise en oeuvre.

La transition de la tension de sortie V0 de sa valeur haute à sa valeur basse intervient lorsque :

$$Vinp - Vinn = Vgs102\text{-}Vgs101 = K[(2I/(1+\alpha))^{1/2}-(2\alpha I/(1+\alpha))^{1/2}]$$

On présente, en relation avec la *figure 2*, un graphique de l'évolution temporelle des première tension d'entrée Vinn, seconde tension d'entrée Vinp, des courants I101, I102, $\alpha$I101 et $\alpha$I102 circulant respectivement dans les transistors M101, M102, M110 et M111 et de la tension de sortie V0.
On peut mesurer à partir des courbes de la première tension d'entrée Vinn et de la tension de sortie V0 l'hystérésis H.
On peut ainsi écrire l'expression de l'amplitude de l'hystérésis de ce comparateur 100 selon :

$$H = 2K[(2I/(1+\alpha))^{1/2}-(2\alpha I/(1+\alpha))^{1/2}]$$

En conséquence, l'amplitude de l'hystérésis dépend principalement de :

- la valeur du courant de la source de courant 2I qui est généralement proportionnelle à la valeur d'une résistance intégrée ou au carré de la valeur de cette résistance intégrée. La valeur de cette résistance intégrée peut varier en fonction de la température ou du process (tel est le cas par exemple d'une résistance en polysilicium). La valeur du courant dépend également de la tension d'alimentation VDD du comparateur 100 ;
- la température ;
- de paramètres technologiques tels que les paramètres v et C0 par exemple ;
- de la qualité de l'appairage de transistors MOS.

On obtient ainsi une précision sur l'hystérésis qui est généralement de l'ordre de $\pm$ 40%. Cette forte imprécision est préjudiciable pour de nombreuses applications dont notamment dans le cadre de la réalisation d'un récepteur de ligne différentielle (permettant d'éliminer des signaux réfléchis) ou pour la réalisation d'un filtre écrêteur de bruit (ou « noise clipping, squelch » en anglais).

## 3. Objectifs de l'invention

L'invention a notamment pour objectif de pallier ces inconvénients de l'art antérieur.

Plus précisément, un objectif de l'invention, dans au moins un de ses modes de réalisation, est de fournir un comparateur de tension à hystérésis dont l'hystérésis est indépendant de la température, de la tension d'alimentation et du process de réalisation du comparateur.

Un autre objectif de l'invention, dans au moins un de ses modes de réalisation, est de mettre en oeuvre un tel comparateur dont l'amplitude de l'hystérésis soit précis et reproductible.

L'invention, dans au moins un de ses modes de réalisation, a encore pour objectif de fournir un tel comparateur qui soit simple à réaliser et pour un faible coût.

## 4. Exposé de l'invention

Ces objectifs, ainsi que d'autres qui apparaîtront par la suite, sont atteints à l'aide d'un comparateur d'une première tension d'entrée et d'une seconde tension d'entrée à hystérésis, comprenant un premier étage différentiel dont des première et seconde entrées sont connectées respectivement aux dites première et seconde tensions d'entrée.

Selon l'invention, un tel comparateur comprend au moins un second étage différentiel symétrique dudit premier étage différentiel, les deux entrées dudit second étage différentiel étant alimentées respectivement par une première et une seconde tensions de référence.

Un tel comparateur comprend d'autre part des moyens de comparaison d'au moins un premier courant, dépendant de la différence entre les première et seconde tensions d'entrée, à au moins un second courant dépendant de la différence entre les seconde et première tensions de référence.

Le principe général de l'invention repose sur l'adjonction à un premier étage différentiel, recevant des tensions à comparer, d'un second étage différentiel symétrique du premier, recevant deux tensions de référence et sur les comparaisons d'un courant dépendant des tensions à comparer à deux courants dépendant chacun d'une des tensions de référence.

Il exploite donc avantageusement la caractéristique selon laquelle la différence entre les courants circulant dans les deux branches d'un étage différentiel ne dépend que de la différence de tension entre les deux transistors de l'étage.

L'invention permet ainsi de réaliser un comparateur de tension à hystérésis dont l'hystérésis est stable, indépendante de la température, de la tension d'alimentation et du process de réalisation du comparateur.

Le comparateur selon l'invention permet également d'ajuster (au moment de la fabrication ou par ajustage dynamique) la valeur de l'hystérésis.

Préférentiellement, les premier et second étages différentiels symétriques sont polarisés par un même courant de polarisation et présentent une charge identique, de façon à optimiser l'appairage des étages différentiels.

Selon une caractéristique avantageuse de l'invention, les moyens de comparaison comprennent au moins une paire de transistors assemblés de façon à former un miroir de courant.

Avantageusement, le premier étage différentiel comprend un premier et un second transistors d'entrée dont les drains sont reliés, les grilles des premier et second transistors d'entrée formant les première et seconde entrées dudit premier étage différentiel, un courant d'entrée circulant dans le second transistors d'entrée, et le second étage différentiel comprend un premier et un second transistors de référence dont les drains sont reliés, les grilles des premier et second transistors de référence recevant les première et seconde tensions de référence, un premier et un second courants de référence circulant dans les premier et second transistors de référence.

Ainsi, aucune résistance n'est mise en oeuvre dans le comparateur selon l'invention. En conséquence, d'une part, le courant d'entrée est très faible et le comparateur peut fonctionner de façon rapide et d'autre part, on obtient un comparateur présentant de faibles dimensions (les résistances occupant une large surface de silicium).

Le comparateur selon l'invention peut recevoir un signal d'entrée dont la fréquence est supérieure à 30 MHz (il présente un temps de comparaison inférieur à 10ns pour un signal différentiel de 1V et une hystérésis de 500m V).

Préférentiellement, les premier et second étages différentiels sont réalisés à partir de composants identiques et présentent les mêmes paramètres de process de fabrication.

Selon un mode de réalisation préférentiel de l'invention, le comparateur comprend des premiers moyens de comparaison du courant d'entrée au premier courant de référence, délivrant au moins une première tension représentative d'un résultat de ladite première comparaison, appelée première tension de comparaison, et des seconds moyens de comparaison du courant d'entrée au second courant de référence, délivrant au moins une seconde tension représentative d'un résultat de ladite seconde comparaison, appelée seconde tension de comparaison.

Préférentiellement :

- la première tension de comparaison prend une première valeur haute si le courant d'entrée est supérieur ou égal au premier courant de référence et prend une première valeur basse sinon ;
- la seconde tension de comparaison prend une seconde valeur haute si le courant d'entrée est supérieur ou égal au second courant de référence et prend une seconde valeur basse sinon.

Avantageusement, les premiers et seconds moyens de comparaisons comprennent au moins une paire de transistors assemblés de façon à former un miroir de courant.

Selon un mode de mise en oeuvre avantageux de l'invention, le comparateur comprend des moyens de génération d'une tension de sortie tenant compte desdites première et seconde tensions de comparaison, ladite tension de sortie pouvant prendre au moins une valeur basse et au moins une valeur haute.

Préférentiellement :

- si les première et seconde tensions de comparaison prennent respectivement les première et seconde valeurs basses alors la tension de sortie prend sa valeur basse ;
- si les première et seconde tensions de comparaison prennent respectivement les première et seconde valeurs hautes alors la tension de sortie prend sa valeur haute.

Avantageusement, une transition de la tension de sortie de sa valeur basse à sa valeur haute est activée par une transition de la seconde tension de comparaison de la seconde valeur basse à la seconde valeur haute lorsque la première tension de comparaison prend la première valeur haute, et une transition de la tension de sortie de sa valeur haute à sa valeur basse est activée par une transition de la première tension de comparaison de la première valeur haute à la première valeur basse lorsque la seconde tension de comparaison prend la seconde valeur basse.

Selon une caractéristique avantageuse de l'invention, les moyens de génération de la tension de sortie comprennent trois portes NAND et une porte OR.

Préférentiellement, la première tension de référence est la masse.

Selon une première caractéristique avantageuse de l'invention, lesdites tensions de référence sont fournies par un montage de type bandgap.

Selon une seconde caractéristique avantageuse de l'invention, lesdites tensions de référence sont fournies par un montage de type pont diviseur de tension associé à un régulateur.

L'invention concerne également un circuit électronique comprenant au moins un comparateur tel que précédemment décrit.

## 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1, déjà décrite ci-dessus, est un schéma d'un comparateur de tensions de l'art antérieur ;
- la figure 2, également décrite ci-dessus, est un graphique de l'évolution temporelle des première tension d'entrée Vinn, seconde tension d'entrée Vinp, des courants I101, I102, $\alpha$I101 et $\alpha$I102 circulant respectivement dans les transistors M101, M102, M110 et M111 et de la tension de sortie V0 du comparateur classique de la figure 1 ;

- la figure 3 est un schéma d'un comparateur 200 de tensions à hystérésis précise selon un mode de réalisation de l'invention ;
- la figure 4 présente une première courbe de l'évolution de I1 / 2I en fonction de (Vgs202-Vgs201) / (I1 / $\upsilon$COW/L)$^{1/2}$ et une seconde courbe de l'évolution de I2 / 2I en fonction de (Vgs202-Vgs201) / (I2 / $\upsilon$C0W/L)$^{1/2}$;
- la figure 5 est un graphique de l'évolution temporelle de la différence entre la seconde tension d'entrée Vinp et la première tension d'entrée Vinn, des courants I202, I211, I212 circulant respectivement dans les second, onzième et douzième transistors M202, M211, M212, des potentiels LTH et HTH et de la tension de sortie V0 dans le cadre du comparateur selon l'invention.

## 6. Description d'un mode de réalisation de l'invention

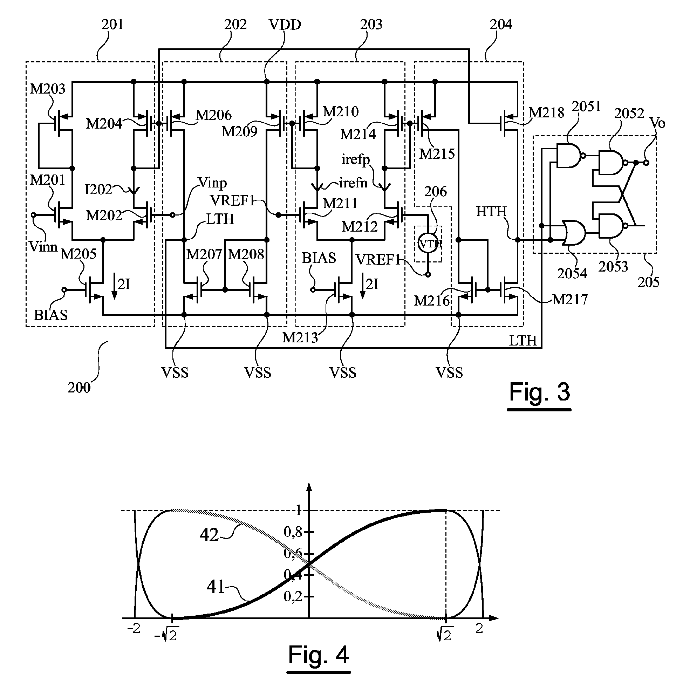

On présente, en relation avec la *figure 3,* un mode de réalisation d'un comparateur 200 de tensions à hystérésis précise selon l'invention.

Ce comparateur 200 comprend :

- un premier étage différentiel 201 comprenant des premier M201, second M202, troisième M203, quatrième M204 et cinquième M205 transistors MOS;
- un premier étage de sortie 202 comprenant des sixième M206, septième M207, huitième M208 et neuvième M209 transistors MOS ;
- un second étage différentiel 203 comprenant des dixième M210, onzième M211, douzième M212, treizième M213 et quatorzième M214 transistors MOS;
- un second étage de sortie 204 comprenant des quinzième M215, seizième M216, dix-septième M217 et dix-huitième M218 transistors MOS et dont une première entrée est alimentée avec une première tension de référence VREF1;
- un troisième étage de sortie 205 permettant de générer la tension de sortie V0 du comparateur, ce troisième étage de sortie comprenant une première 2051, une seconde 2052 et une troisième 2053 porte NAND et une porte OR 2054 ;
- une source de tension 206 délivrant, à une seconde entrée du second étage différentiel 203, une seconde tension de référence VTH + VREF1, VTH est une tension différentielle entre la seconde et la première entrée (sur laquelle est appliquée le potentiel VREF1) du second étage différentiel 203.

LTH et HTH sont respectivement, le potentiel mesuré au niveau du drain du septième transistor M207 et le potentiel au niveau du drain du dix-septième transistor M217.

Le troisième étage de sortie 205 est tel que :

- si HTH = LTH = 0 alors V0 = 0 ;
- si LTH = 1, HTH = 0 alors V0 conserve son état, c'est-à-dire que si V0 était à 0 avant le passage à cet état, V0 reste à 0, si V0 était à 1, il reste à 1;
- si HTH = LTH = 1 alors V0 = 1.

Les transistors M203, M204, M206, M209, M219, M214, M215 et M218 sont des transistors MOS de type P, les autres transistors précités sont des transistors MOS de type N.

La tension VTH peut être fournie par un montage de type pont diviseur de tension, associé à un régulateur, ou, pour une plus grande précision, à une référence de type bandgap.

La première tension de référence VREF1 doit être supérieure à une tension minimum VREFmin dépendant du process de fabrication du comparateur (on choisit par exemple VREF1=1V). Elle peut être fournie par un montage de type pont diviseur de tension.

Les première et seconde entrées du premier étage différentiel 201 sont alimentées avec une première Vinn et une seconde Vinp tensions d'entrée à comparer.

Le comparateur 200 est alimenté au moyen d'une tension d'alimentation VDD et délivre une tension de sortie V0.

Dans le cas d'un transistor MOS fonctionnant en régime saturé, la relation entre le courant de drain I et la tension grille - source Vgs est donnée par :

$$I = \upsilon C0.W/L(Vgs-VT)^2$$

On obtient donc la relation suivante :

$$Vgs = (I/\upsilon C0.W/L)^{1/2}+VT$$

où $\upsilon$ est la mobilité de l'électron, C0 est la capacité d'oxyde de grille par unité de surface, W et L sont respectivement les largeur et longueur de canal MOS et VT est une tension de seuil.

Le $i^{\text{ème}}$ transistor M2i, pour i compris entre 01 et 11, possède un canal de largeur W2i et de longueur L2i et est traversé par un courant 12i.

Les premier 201 et second 203 étage différentiels sont symétriques et sont donc réalisés avec les mêmes composants. Ainsi, les premier M201, second M202, troisième M203, quatrième M204 et cinquième M205 transistors sont identiques respectivement aux onzième M211, douzième M212, dixième M210, quatorzième M214 et treizième M213 transistors.

Les grilles des cinquième M205 et treizième M213 transistors sont reliées à un potentiel BIAS fourni par un générateur de courant externe. On peut choisir par exemple une valeur de BIAS sensiblement égale à 1V.

Avantageusement, le générateur de courant externe est le générateur de courant externe décrit en relation avec la figure 3 du document de demande de brevet français n°FR0208650.

On suppose que :

- W201 = W202 = W211 = W212 = W
- L201 = L202 = L211 = L212 = L
- W205 = W213 et
- L205 = L213

alors on peut écrire les relations suivantes :

$$Vgs202\text{-}Vgs201 = (I2/\upsilon C0.W/L)^{1/2}\text{-}(I1/\upsilon C0.W/L)^{1/2}$$

$$Vgs212\text{-}Vgs211 = (I12/\upsilon C0.W/L)^{1/2}\text{-}(I11/\upsilon C0.W/L)^{1/2}$$

où Vgs201, Vgs202, Vgs211 et Vgs212 sont les tensions grille-source respectivement des premier M201, second M202, onzième M211 et douzième M212 transistors.

Du fait que les deux étages différentiels sont symétriques, on peut également écrire les relations suivantes :

- I201 + I202 = 2I et
- I211 + I212 = 2I

où 21 est le courant traversant les cinquième M205 et treizième M213 transistors.

On peut donc écrire les relations suivantes :

$$Vgs202\text{-}Vgs201=(I202/\upsilon C0.W/L)^{1/2}\text{-}((2I\text{-}I202)/\upsilon C0.W/L)^{1/2}$$

$$Vgs202\text{-}Vgs201=((2I\text{-}I201)/\upsilon C0.W/L)^{1/2}\text{-}(I201/\upsilon C0.W/L)^{1/2}$$

et

$$Vgs212\text{-}Vgs211=(I212/\upsilon C0.W/L)^{1/2}\text{-}((2I\text{-}I212)/\upsilon C0W/L)^{1/2}$$

$$Vgs212 - Vgs211 = ((2I - I211)/\upsilon C0.W/L)^{1/2} - (I211/\upsilon C0W/L)^{1/2}$$

On présente, en relation avec la *figure 4*, sur une première courbe 41, l'évolution de I1 / 2I en fonction de $(Vgs202 - Vgs201) / (I1 / \upsilon C0W/L)^{1/2}$ et, sur une seconde courbe 42, l'évolution de I2 / 2I en fonction de $(Vgs202 - Vgs201) / (I2 / \upsilon C0W/L)^{1/2}$.

Ainsi, pour la même différence de tension dV = Vgs202-Vgs201 = Vgs212-Vgs211 appliquée entre les seconde et première entrées respectivement des premier 201 et second 203 étages différentiels (on rappelle que W201 = W202 = W211 = W212 = W, L201 = L202 = L211 = L212 = L), les courants de drain I201, I211 d'une part, I202, I212 d'autre part des deux étages différentiels 201, 203 sont identiques :

$$I201 = I211$$

$$I202 = I212$$

Alors, en se rappelant que :

- W204 = W206 = W218 ;
- L204 = L206 = L218 ;
- W209 = W210 = W214 = W215;
- L209 = L210 = L214 = L215 ;
- W207 = W208 = W216 = W217 et
- L207 = L208 = L216 = L217.

On obtient les relations suivantes :

- I202 = I204 = I206 = I218 ;
- I207 = I208 = I209 = I210 = I211 ;
- I212 = I214 = I215 = I216 = I217.

Si l'on se place dans le cas où : Vinp - Vinn << VTH :

- I201 = 21 ;
- I202 = I206 = I218 = 0;
- I211 = I207 = Irefn (car les paires de transistors M210, M209 et M208, M207 sont disposées en miroir de courant donc I210 = I209 et I208 = I207);
- I212 = I217 = Irefp (car les paires de transistors M214, M215 et M216, M217 sont disposées en miroir de courant donc I214 = I215 et I216 = I217) et
- LTH = HTH = V0 = 0

où Irefn, Irefp, LTH, HTH sont le courant circulant dans le onzième transistor M211, le courant circulant dans le douzième transistor M212, le potentiel mesuré au niveau du drain du septième transistor M207 et le potentiel au niveau du drain du dix-septième transistor M217.

Si la seconde tension d'entrée Vinp augmente, à un moment, le courant I206 traversant le sixième transistor M206 devient supérieur au courant I207 traversant le septième transistor M207 (ce dernier courant I207 étant égal au courant Irefn circulant dans le onzième transistor), le potentiel LTH devient égal au potentiel d'alimentation VDD, mais le potentiel HTH et la tension de sortie V0 restent nulles.

Lorsque l'on obtient la relation suivante :

$$vinp - vinn = VTH$$

alors, on peut observer la relation suivante :

$$I206 = I218 = I217 = Irefp$$

et le potentiel HTH ainsi que la tension de sortie V0 commutent de 0V à la valeur du potentiel d'alimentation VDD.

Si l'on se place dans le cas où : Vinp - Vinn >> VTH :

- I201= 0 ;
- I202 = I206 = I218 = 2I;
- I211 = I207 = Irefn ;
- I212 = I217 = Irefp et
- LTH = HTH = V0 = VDD

Si la seconde tension d'entrée diminue, à un moment, le courant I218 traversant le dix-huitième transistor M218 devient inférieur au courant I217 (ce dernier courant I217 étant égal au courant Irefp circulant dans le douzième transistor M212), le potentiel HTH devient nul, mais le potentiel LTH et la tension de sortie V0 restent égaux au potentiel d'alimentation VDD.

Lorsque l'on obtient la relation suivante :

$$Vinn - Vinp = VTH$$

alors, on peut observer la relation suivante :

$$I206 = I218 = I207 = Irefn$$

et le potentiel LTH ainsi que la tension de sortie V0 commutent de la valeur du potentiel d'alimentation VDD à 0V.

L'amplitude de l'hystérésis de ce comparateur 200 est de 2VTH.

Ainsi, dans le cadre du comparateur 200 selon ce mode de réalisation de l'invention, si l'on suppose que les premier 201 et second 203 étages différentiels sont identiques et appairés et que grâce aux montages miroirs de courant, les courants des étages de sortie 202, 204 sont également identiques, l'amplitude de l'hystérésis est indépendante du process de réalisation du comparateur 200, de la température et de la tension d'alimentation VDD.

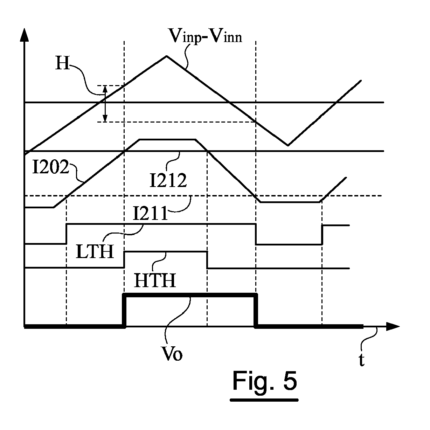

Afm de résumer le comportement en fonction du temps des principales caractéristiques du comparateur 200 selon l'invention, on présente, en relation avec la *figure 5*, un graphique de l'évolution temporelle de la différence entre la seconde tension d'entrée Vinp et la première tension d'entrée Vinn, des courants I202, I211, I212 circulant respectivement dans les second, onzième et douzième transistors M202, M211, M212, des potentiels LTH et HTH et de la tension de sortie V0.

On peut mesurer à partir des courbes de la figure 5 l'hystérésis H.

Ce comparateur 200 a été simulé pour une technologie de réalisation de 0,35$\mu$m en faisant varier la température de -40°C à 118°C et pour une valeur du potentiel d'alimentation VDD variant de 4,5V à 5,5V.

Dans une première simulation, la tension VTH varie entre 368mV et 392mV sur la plage de température considérée, et varie entre 317mV et 421mV sur toutes les plages de variations considérées (température, valeur du potentiel d'alimentation,...), ce qui correspond à une variation de VTH de +/-16%.

Dans ces conditions, l'amplitude d'hystérésis varie entre 663 mV et 859 mV, ce qui correspond à une variation de l'amplitude d'hystérésis de +/-15 %.

Dans une seconde simulation, la tension VTH vaut sensiblement 0,35V et est très stable, et l'amplitude d'hystérésis varie entre 718mV et 750mV, ce qui correspond à une variation de l'amplitude d'hystérésis de +/-2%. On obtient ainsi une hystérésis très précise, dont l'amplitude ne varie quasiment pas avec les température, process ou tension d'alimentation du comparateur 200.

Bien entendu, l'invention n'est pas limitée aux exemples de réalisation mentionnés ci-dessus.

En particulier, l'Homme du Métier pourra apporter toute variante dans le mode de réalisation précédemment décrit et notamment dans le choix des transistors du comparateur.

Il peut par exemple :

- utiliser une architecture de comparateur différente,
- utiliser des tansistors d'une autre technologie (bipolaires ...).

**Revendications**

1. Comparateur d'une première tension d'entrée (Vinn) et d'une seconde tension d'entrée (Vinp) à hystéréris, comprenant un premier étage différentiel dont des première et seconde entrées sont alimentées respectivement par lesdites première et seconde tensions d'entrée,
**caractérisé en ce qu'**il comprend au moins un second étage différentiel symétrique dudit premier étage différentiel, deux entrées dudit second étage différentiel étant alimentées respectivement par une première (VREF1) et une seconde tensions de référence (VREF1+VTH),
et **en ce qu'**il comprend des moyens de comparaison d'au moins un premier courant (I2), dépendant de la différence entre les première (Vinn) et seconde (Vinp) tensions d'entrée, à au moins un second courant (Irefn, Irefp) dépendant de la différence (VTH) entre les seconde et première tensions de référence.

2. Comparateur selon la revendication 1, **caractérisé en ce que** lesdits premier et second étages différentiels symétriques sont polarisés par un même courant de polarisation et présentent une charge identique, de façon à optimiser l'appairage desdits étages différentiels.

3. Comparateur selon l'une quelconque des revendications 1 et 2, **caractérisé en ce que** lesdits moyens de comparaison comprennent au moins une paire de transistors assemblés de façon à former un miroir de courant.

4. Comparateur selon l'une quelconque des revendications 1 à 3, **caractérisé en ce que** le premier étage différentiel comprend un premier (M201) et un second (M202) transistors d'entrée dont les drains sont reliés, les grilles des premier (M201) et second (M202) transistors d'entrée formant les première et seconde entrées dudit premier étage différentiel, un courant d'entrée (I202) circulant dans le second (M202) transistors d'entrée,
et **en ce que** le second étage différentiel comprend un premier (M211) et un second (M212) transistors de référence dont les drains sont reliés, les grilles des premier (M211) et second (M212) transistors de référence recevant les première (VREF1) et seconde (VREF1+VTH) tensions de référence, un premier (Irefn) et un second (Irefp) courants de référence circulant dans les premier (M211) et second (M212) transistors de référence.

5. Comparateur selon l'une quelconque des revendications 1 à 4, **caractérisé en ce que** lesdits premier et second étages différentiels sont réalisés à partir de composants identiques et présentent les mêmes paramètres de process de fabrication.

6. Comparateur selon la revendication 4, **caractérisé en ce qu'**il comprend des premiers moyens de comparaison du courant d'entrée (I202) au premier courant de référence (Irefn), délivrant au moins une première tension (LTH) représentative d'un résultat de ladite première comparaison, appelée première tension de comparaison, et des seconds moyens de comparaison du courant d'entrée (I202) au second courant de référence (Irefp), délivrant au moins une seconde tension (HTH) représentative d'un résultat de ladite seconde comparaison, appelée seconde tension de comparaison.

7. Comparateur selon la revendication 6, **caractérisé en ce que** :

   - la première tension de comparaison (LTH) prend une première valeur haute si le courant d'entrée (I202) est supérieur ou égal au premier courant de référence (Irefn) et prend une première valeur basse sinon ;
   - la seconde tension de comparaison (HTH) prend une seconde valeur haute si le courant d'entrée (I202) est supérieur ou égal au second courant de référence (Irefp) et prend une seconde valeur basse sinon.

8. Comparateur selon l'une quelconque des revendications 6 et 7, **caractérisé en ce que** les premiers et seconds moyens de comparaisons comprennent au moins une paire de transistors assemblés de façon à former un miroir de courant.

9. Comparateur selon l'une quelconque des revendications 6 à 8, **caractérisé en ce qu'**il comprend des moyens de génération d'une tension de sortie (V0) tenant compte desdites première (LTH) et seconde (HTH) tensions de comparaison, ladite tension de sortie (V0) pouvant prendre au moins une valeur basse et au moins une valeur haute.

**10.** Comparateur selon la revendication 9, **caractérisé en ce que** :

- si les première (LTH) et seconde (HTH) tensions de comparaison prennent respectivement les première et seconde valeurs basses alors la tension de sortie (V0) prend sa valeur basse ;
- si les première (LTH) et seconde (HTH) tensions de comparaison prennent respectivement les première et seconde valeurs hautes alors la tension de sortie (V0) prend sa valeur haute.

**11.** Comparateur selon l'une quelconque des revendications 9 et 10, **caractérisé en ce qu'**une transition de la tension de sortie (V0) de sa valeur basse à sa valeur haute est activée par une transition de la seconde tension de comparaison (HTH) de la seconde valeur basse à la seconde valeur haute lorsque la première tension de comparaison (LTH) prend la première valeur haute,
et **en ce qu'**une transition de la tension de sortie (V0) de sa valeur haute à sa valeur basse est activée par une transition de la première tension de comparaison (LTH) de la première valeur haute à la première valeur basse lorsque la seconde tension de comparaison (HTH) prend la seconde valeur basse.

**12.** Comparateur selon l'une quelconque des revendications 9 à 11, **caractérisé en ce que** les moyens de génération de la tension de sortie (V0) comprennent trois portes NAND et une porte OR.

**13.** Comparateur selon l'une quelconques des revendications 1 à 12, **caractérisé en ce que** lesdites tensions de référence sont fournies par un montage de type bandgap.

**14.** Comparateur selon l'une quelconques des revendications 1 à 12, **caractérisé en ce que** lesdites tensions de référence sont fournies par un montage de type pont diviseur de tension associé à un régulateur.

**15.** Circuit électronique **caractérisé en ce qu'**il comprend un comparateur selon l'une quelconque des revendications 1 à 14.

**Revendications modifiées conformément à la règle 86(2) CBE.**

**1.** Comparateur d'une première tension d'entrée (Vinn) et d'une seconde tension d'entrée (Vinp) à hystéréris, comprenant un premier étage différentiel dont des première et seconde entrées sont alimentées respectivement par lesdites première et seconde tensions d'entrée,
**caractérisé en ce qu'**il comprend au moins un second étage différentiel symétrique dudit premier étage différentiel, deux entrées dudit second étage différentiel étant alimentées respectivement par une première (VREF1) et une seconde tensions de référence (VREF1+VTH),
et **en ce qu'**il comprend des premiers moyens de comparaison d'au moins un premier courant (12), dépendant uniquement de la différence entre les première (Vinn) et seconde (Vinp) tensions d'entrée, à au moins un second courant (Irefn) dépendant uniquement de la différence (VTH) entre les seconde et première tensions de référence et des seconds moyens de comparaison dudit au moins un premier courant (12) à au moins un troisième courant (Irefp), dépendant uniquement de la différence (VTH) entre les seconde et première tensions de référence, lesdits premiers et seconds moyens de comparaison étant distincts.

**2.** Comparateur selon la revendication 1, **caractérisé en ce que** lesdits premier et second étages différentiels symétriques sont polarisés par un même courant de polarisation et présentent une charge identique, de façon à optimiser l'appairage desdits étages différentiels.

**3.** Comparateur selon l'une quelconque des revendications 1 et 2, **caractérisé en ce que** lesdits premiers et seconds moyens de comparaison comprennent au moins une paire de transistors assemblés de façon à former un miroir de courant.

**4.** Comparateur selon l'une quelconque des revendications 1 à 3, **caractérisé en ce que** le premier étage différentiel comprend un premier (M201) et un second (M202) transistors d'entrée dont les drains sont reliés, les grilles des premier (M201) et second (M202) transistors d'entrée formant les première et seconde entrées dudit premier étage différentiel, un courant d'entrée (I202) circulant dans le second (M202) transistors d'entrée,
et **en ce que** le second étage différentiel comprend un premier (M211) et un second (M212) transistors de référence dont les drains sont reliés, les grilles des premier (M211) et second (M212) transistors de référence recevant les première (VREF1) et seconde (VREF1+VTH) tensions de référence, un premier (Irefn) et un second (Irefp) courants de référence circulant dans les premier (M211) et second (M212) transistors de référence.

**5.** Comparateur selon l'une quelconque des revendications 1 à 4, **caractérisé en ce que** lesdits premier et second étages différentiels sont réalisés à partir de composants identiques et présentent les mêmes paramètres de process de fabrication.

**6.** Comparateur selon la revendication 4, **caractérisé en ce qu'**il comprend les premiers moyens de comparaison sont des premiers moyens de comparaison du courant d'entrée (I202) au premier courant de référence (Irefn), délivrant au moins une première tension (LTH) représentative d'un résultat de ladite première comparaison, appelée première tension de comparaison, et les seconds moyens de comparaison sont des seconds moyens de comparaison du courant d'entrée (I202) au second courant de référence (Irefp), délivrant au moins une seconde tension (HTH) représentative d'un résultat de ladite seconde comparaison, appelée seconde tension de comparaison.

**7.** Comparateur selon la revendication 6, **caractérisé en ce que** :

- la première tension de comparaison (LTH) prend une première valeur haute si le courant d'entrée (1202) est supérieur ou égal au premier courant de référence (Irefn) et prend une première valeur basse sinon ;
- la seconde tension de comparaison (HTH) prend une seconde valeur haute si le courant d'entrée (1202) est supérieur ou égal au second courant de référence (Irefp) et prend une seconde valeur basse sinon.

**8.** Comparateur selon l'une quelconque des revendications 6 et 7, **caractérisé en ce que** les premiers et seconds moyens de comparaisons comprennent au moins une paire de transistors assemblés de façon à former un miroir de courant

**9.** Comparateur selon l'une quelconque des revendications 6 à 8, **caractérisé en ce qu'**il comprend des moyens de génération d'une tension de sortie (V0) tenant compte desdites première (LTH) et seconde (HTH) tensions de comparaison, ladite tension de sortie (V0) pouvant prendre au moins une valeur basse et au moins une valeur haute.

**10.** Comparateur selon la revendication 9, **caractérisé en ce que**:

- si les première (LTH) et seconde (HTH) tensions de comparaison prennent respectivement les première et seconde valeurs basses alors la tension de sortie (V0) prend sa valeur basse ;
- si les première (LTH) et seconde (HTH) tensions de comparaison prennent respectivement les première et seconde valeurs hautes alors la tension de sortie (V0) prend sa valeur haute.

**11.** Comparateur selon l'une quelconque des revendications 9 et 10, **caractérisé en ce qu'**une transition de la tension de sortie (V0) de sa valeur basse à sa valeur haute est activée par une transition de la seconde tension de comparaison (HTH) de la seconde valeur basse à la seconde valeur haute lorsque la première tension de comparaison (LTH) prend la première valeur haute,
et **en ce qu'**une transition de la tension de sortie (V0) de sa valeur haute à sa valeur basse est activée par une transition de la première tension de comparaison (LTH) de la première valeur haute à la première valeur basse lorsque la seconde tension de comparaison (HTH) prend la seconde valeur basse.

**12.** Comparateur selon l'une quelconque des revendications 9 à 11, **caractérisé en ce que** les moyens de génération de la tension de sortie (V0) comprennent trois portes NAND et une porte OR.

**13.** Comparateur selon l'une quelconques des revendications 1 à 12, **caractérisé en ce que** lesdites tensions de référence sont fournies par un montage de type bandgap.

**14.** Comparateur selon l'une quelconques des revendications 1 à 12, **caractérisé en ce que** lesdites tensions de référence sont fournies par un montage de type pont diviseur de tension associé à un régulateur.

**15.** Circuit électronique **caractérisé en ce qu'**il comprend un comparateur selon l'une quelconque des revendications 1 à 14.

Fig. 1

Fig. 2

Fig. 3

Fig. 4

$V_{inp}-V_{inn}$

H

I202

I212

I211

LTH

HTH

Vo

t

### Fig. 5

**Office européen
des brevets**

**RAPPORT DE RECHERCHE EUROPEENNE**

Numéro de la demande

EP 06 11 9192

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 5 528 185 A (LEWICKI ET AL) 18 juin 1996 (1996-06-18) * figure 2 * | 1-3,5 | INV. H03K3/3565 |
| A | EP 0 594 305 A (ADVANCED MICRO DEVICES, INC) 27 avril 1994 (1994-04-27) * figure 2 * | 1 | |
| A | US 6 229 346 B1 (MILANESE CARLO MARIA ET AL) 8 mai 2001 (2001-05-08) * figure 3 * | 1 | |

| DOMAINES TECHNIQUES RECHERCHES (IPC) |
|---|
| H03K |

Le présent rapport a été établi pour toutes les revendications

| Lieu de la recherche | Date d'achèvement de la recherche | Examinateur |
|---|---|---|
| Munich | 27 octobre 2006 | Brown, Julian |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 06 11 9192

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-10-2006

| Document brevet cité au rapport de recherche | | | Date de publication | Membre(s) de la famille de brevet(s) | | Date de publication |
|---|---|---|---|---|---|---|
| US 5528185 | A | | 18-06-1996 | AUCUN | | |
| EP 0594305 | A | | 27-04-1994 | DE | 69317350 D1 | 16-04-1998 |
| | | | | JP | 3574162 B2 | 06-10-2004 |
| | | | | JP | 6204820 A | 22-07-1994 |
| | | | | US | 5446396 A | 29-08-1995 |
| US 6229346 | B1 | | 08-05-2001 | IT | VA990005 A1 | 22-08-2000 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 0208650